# EUROPEAN PATENT SPECIFICATION

(11) **EP 0 530 825 B1**
(45) Date of publication and mention of the grant of the patent: **06.03.1996**
(21) Application number: 92115165.0
(22) Date of filing: 04.09.1992
(51) Int. Cl.: C30B 15/12, C30B 15/10, C30B 35/00

(54) **A single crystal growing apparatus**
Vorrichtung zum Züchten von Einkristallen
Appareillage pour la croissance de monocristaux

(30) Priority: 04.09.1991 JP 224413/91
(43) Date of publication of application: 10.03.1993
(73) Proprietor: MITSUBISHI MATERIALS CORPORATION, Chiyoda-ku, Tokyo (JP); MITSUBISHI MATERIALS QUARTZ CORPORATION, Akita-shi, Akita-ken (JP)
(72) Inventor: Arai, Yoshiaki, c/o Chuo-Kenkyusho, Mitsubishi, Omiya-shi, Saitama-ken (JP); Kida, Michio, c/o Chuo-Kenkyusho, Mitsubishi, Omiya-shi, Saitama-ken (JP); Ono, Naoki, c/o Chuo-Kenkyusho, Mitsubishi, Omiya-shi, Saitama-ken (JP); Sahira, Kensho, c/o Chuo-Kenkyusho, Mitsubishi, Omiya-shi, Saitama-ken (JP); Takeshita, Motomi, c/o Mitsubishi Materials, Akita-shi, Akita-ken (JP); Sugiura, Kengo, c/o Mitsubishi Materials, Akita-shi, Akita-ken (JP)
(74) Representative: Füchsle, Klaus, Dipl.-Ing.

(56) References cited:
- EP-A- 0 319 031
- EP-A- 0 368 586
- EP-A- 0 400 266
- PATENT ABSTRACTS OF JAPAN vol. 14, no. 275 (C-728)14 June 1990
- PATENT ABSTRACTS OF JAPAN vol. 13, no. 494 (C-651)(3842) 8 November 1989

## Description

The present invention relates to a single crystal growing apparatus for growing a single crystal ingot from a molten semiconductor material in a crucible assembly comprising at least two crucibles, an outer crucible and a transparent inner crucible, with high durability to provide a high efficiency of mono-crystallization in the process of growing single crystals.

A single crystal growing apparatus used in the conventional crystal growth method such as Czochralski method generally comprises a closed-type chamber, a quartz crucible assembly provided in the closed-type chamber, and a heating element for heating a quantity of high-purity molten semiconductor material which is contained within the crucible assembly.

In the single crystal growing process using the above apparatus, a seed crystal is brought into contact with the molten semiconductor material. The seed is then pulled slowly upwards, resulting in the molten material solidifying at the seed-melt interface and forming a single crystal ingot.

The above conventional crucible assembly comprises at least two crucibles, an outer crucible and an inner crucible, the later is coaxially fixed in the former.

The conventional inner crucible is a semi-transparent quartz bowl manufactured by a conventional spin molding method comprising the steps of:
(i) accumulating a raw material of quartz powders on an inner wall of a graphite mold having a bowl shape;
(ii) heating an accumulated quartz powders by arc flame or the like to melt them to make a molten quartz glass.

For easily detaching the resulting crucible from the mold, the above heating step is performed so that the quartz powders localized on the interface between the mold and the layer are not sufficiently subjected to the arc flame. As a result, an uneven opaque layer containing micro air-bubbles in the remaining powders is formed especially on an outer peripheral surface of the obtained crucible.

Accordingly, the outer peripheral surface of the resulting crucible should be shaved by subjecting the surface to a high pressurized water jet, grinding or polishing, chemical such as hydrofluoric acid, or the like after the above process.

Recently, the semiconductor device industry has advanced remarkably and high quality single crystals have been required. In spite of the industrial requirement, the conventional growing apparatus frequently produces crystals with some defects, impurities or the like during the crystal growing process. Therefore, there has been a need to improve the crystal growing apparatus for producing a semiconductor crystal with a high quality.

The inventors of the present invention have discovered that the above troubles are caused primarily by the remaining quartz powders in the inner crucible.

These remaining powders are easily pealed off from a surface of the inner crucible during the crystal growing process because the air bubbles formed in the crucible are expanded, so the remaining powders are pushed out from the surface. Therefore, an amount of the remaining powders in the crucible should be limited to a constant low level.

A crystal growing apparatus according to the preamble of claim 1 including a transparent inner crucible is known from JP-A-2083295. EP-A-0 319 031 also discloses an apparatus for growing a single crystal, said apparatus including a crucible and an inner transparent glass layer.

It is the object of the present invention to provide a crystal growing apparatus having an inner crucible which is made of transparent quartz not only for obtaining a high durability but also for providing a high efficiency of mono-crystallisation of the crystal ingot.

Other objects, purposes and characteristics features of the present invention will be in part obvious from the accompanying drawings, and in art pointed out by the text.

In the crystal growing apparatus in accordance with the present invention as described in claim 1, the air bubbles contained in an outer surface of the inner crucible should be limited to 0.05% or less of the total volume of the crucible.

Further, a mean diameter of the air bubbles contained in the inner crucible is not more than 40 µm.

FIG. 1 shows a longitudinal cross-sectional view of a crystal growing apparatus in accordance with the present invention.

FIG. 2 shows a longitudinal cross-sectional view of another crystal growing apparatus in accordance with the present invention.

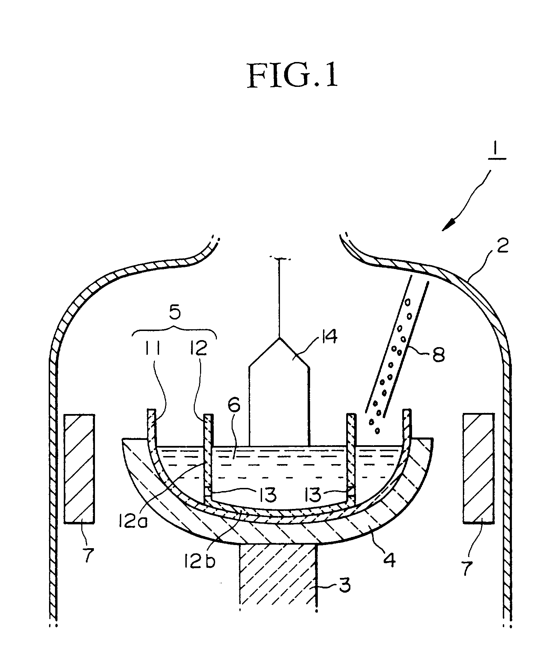

FIG. 1 depicts a crystal growing apparatus in accordance with the present invention, indicated by numeral 1, generally comprising a closed-type chamber 2; a drive shaft 3; a graphite receptacle 4; a quartz crucible assembly 5; a heating element 7 for heating a molten semiconductor material 6; crystal pulling mechanism 14; and a means 8 of supplying the crucible with a raw material.

The closed-type chamber 2 is filled with an inert gas such as argon at a low pressure, wherein the graphite receptacle 4 and the quartz crucible assembly 5 are provided.

The drive shaft 3 is responsible for rotating the crucible assembly at a predetermined angular speed.

The graphite receptacle 4 is in the form of a deep dish with a uniform hemispherical inner surface and a sufficient wall thickness. Also the receptacle 4 is seated within the chamber 2 so as to surround the quartz crucible assembly 5 and is coaxially connected to the driving shaft 3 so as to rotate the crucible assembly 5 at a predetermined angular speed.

In this embodiment, the crucible assembly 5 comprises two different sized crucibles 11, 12 having a uniform hemispherical inner surface. The inner crucible 12 is coaxially seated within the outer crucible 11. More than one opening hole 13 is formed in a wall of the inner crucible 11 so as to pass the molten material through the outer crucible 11 to the inner crucible 12.

The inner crucible 12 is a transparent quartz glassware having a cylindrical side wall 12a and a curved bottom wall 12b.

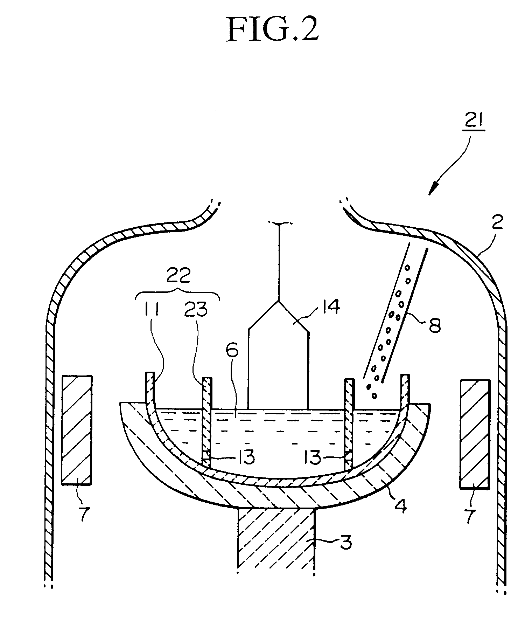

As shown in FIG. 2, the curved bottom wall 12b is not an essential constituent.

FIG. 2 depicts another embodiment of the present invention which is almost the same as the first embodiment, excepting that an inner crucible 23 of the second embodiment does not have a bottom wall 12b.

In each embodiment, the inner crucible 12 or 23 contains a limited amount of air bubbles, i.e., 0.05% or less of the total volume of the crucible. A light transmissivity of the inner crucible 1 or 23 is not less than 70 % of the total under UV or visible light of 240 nm or over wave length.

It is noted that a mean diameter of the air bubbles contaminated in the inner crucible 12 or 23 is limited to 40 µm or less.

For the process of growing a single crystal, a quantity of high-purity molten semiconductor material such as silicon or germanium is supplied within the quartz crucible assembly 5 and the material is maintained in a molten state by the heating element 7 in the form of a cylinder which may comprise a resistance heater.

### Examples 1-4:

Inner crucible of example 1-4 were manufactured by the conventional method as described above, except that the step of removing the remaining quartz powders and the air bubbles was performed more perfectly compared with the conventional one to satisfy the conditions of that an amount of air bubbles contained in the crucible is not more than 0.05% of the total volume of the crucible; a mean diameter of the air bubbles contained in the inner crucible is not more than 40 µm; and a light transmissivity of the inner crucible is not less than 70 % under UV or visible light of 240 nm of over wave length.

### Comparative examples:

Inner crucibles of the examples 5-8 as the comparatives were manufactured by the conventional method as described above.

The characteristics of the obtained single crystal ingot from the crucibles of the examples 1-4 and the comparative examples 5-8 are listed in Table 1 below.

In the table, OSF means Oxydation-induced Stacking Fault;
○ means that the crystal obtained is of good quality;
Δ means that the crystal obtained is of allowable quality; and
X means that the crystal obtained is of poor quality.

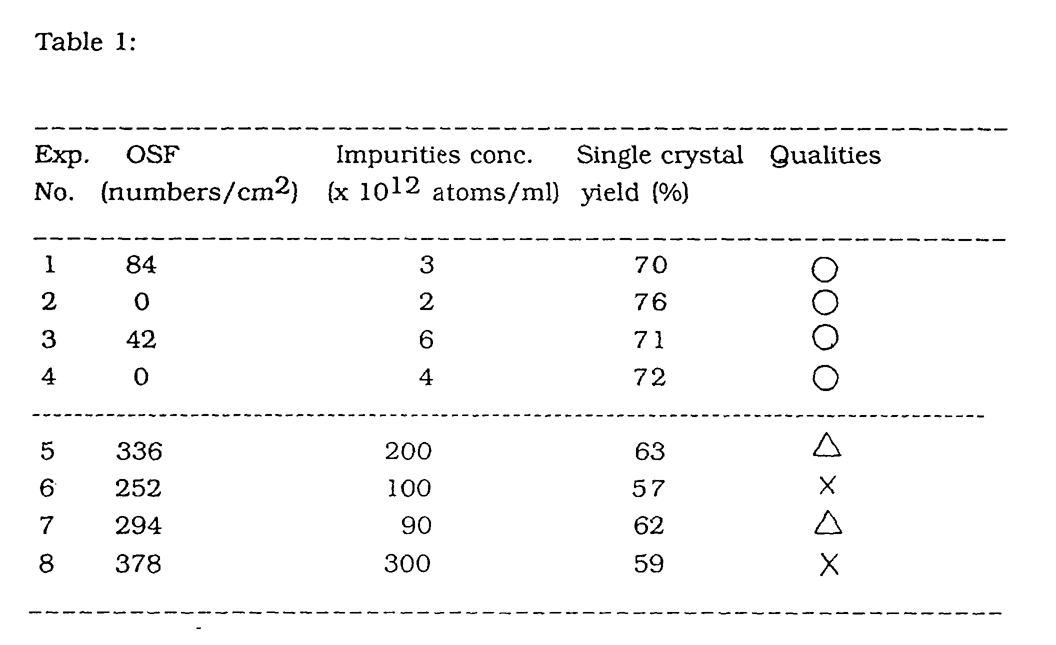

As shown in the table, the novel crystal growing apparatus according to the present invention provides a single crystal having an extremely low numerical value of the oxydation-induced stacking fault (OSF). Also the single crystal obtained by the apparatus of the present invention is hardly contaminated with impurities, as compared with the single crystal obtained by the conventional apparatus.

It is further noted that a yielding of the single crystal of the present invention is higher than that of the conventional one.

Consequently, the crystal growing apparatus according to the present invention avoids the troubles caused by the remaining powders.

## Claims

1. A crystal growing apparatus including a closed-type chamber being filled with an inert gas such as argon at a low pressure, a graphite receptacle, a quartz crucible assembly comprising at least two crucibles coaxially seated in said receptacle, a driving shaft coaxially connected to said receptacle for rotating said receptacle and said crucible assembly, a heating element for heating a molten semiconductor material, a crystal pulling mechanism for pulling a single crystal from said semiconductor material, and a means for supplying said crucible assembly with a raw material, said quartz crucible assembly having a transparent quartz inner crucible seated in an outer crucible, **characterized in that** said transparent inner crucible has a light transmissivity of not less than 70% when exposed under a light with a wavelength of 240nm or greater, and contains air bubbles, contained substantially in quartz powdery material, in a outer peripheral surface of said inner crucible, having a mean bubble diameter of not more than 40 µm in an amount not exceeding 0.05^{%} of the total volume of said inner crucible.

## Patentansprüche

1. Kristall-Züchtvorrichtung mit einer geschlossenen Kammer, die mit einem Inertgas wie Argon bei niedrigem Druck gefüllt ist, einem Graphitbehälter, einer Quarztiegelanordnung mit wenigstens zwei Tiegeln, die koaxial in dem Behälter sitzen, einer Antriebswelle, die koaxial mit dem Behälter zum Drehen des Behälters und der Tiegelanordnung verbunden ist, einem Heizelement zum Erhitzen eines geschmolzenen Halbleitermaterials, einer Kristallzieheinrichtung zum Ziehen eines Einkristalls aus dem Halbleitermaterial und einer Einrichtung zur Versorgung der Tiegelanordnung mit einem Rohmaterial, wobei die Quarztiegelanordnung einen transparenten inneren Quarztiegel aufweist, der in einem äußeren Tiegel sitzt,
**dadurch gekennzeichnet**, daß der transparente innere Tiegel eine Lichtdurchlässigkeit von nicht weniger als 70 % aufweist, wenn er einem Licht mit einer Wellenlänge von 240 nm oder größer ausgesetzt ist, und Luftblasen, die im wesentlichen in Quarzmehlmaterial in einer äußeren Randfläche des inneren Tiegels enthalten sind, mit einem durchschnittlichen Blasendurchmesser von nicht mehr als 40 µm in einer Menge aufweist, die 0,05 % des Gesamtvolumens des inneren Tiegels nicht überschreitet.

## Revendications

1. Appareil de croissance de cristaux comprenant une enceinte du type fermé qui est remplie d'un gaz inerte tel que de l'argon à basse pression, un réceptacle de graphite, un montage de creusets en quartz comprenant au moins deux creusets disposés de façon coaxiale dans ledit réceptacle, un axe d'entraînement relié de façon coaxiale audit réceptacle afin d'entraîner en rotation ledit réceptacle et ledit ensemble de creusets, un élément chauffant destiné à chauffer un matériau de semiconducteur fondu, un mécanisme de retrait de cristal afin de retirer un monocristal dudit matériau de semiconducteur, et un moyen destiné à alimenter ledit ensemble de creusets en matériau brut, ledit ensemble de creusets en quartz comportant un creuset intérieur en quartz transparent disposé dans un creuset extérieur, caractérisé en ce que ledit- creuset intérieur transparent présente un facteur de transmission de la lumière qui n'est pas inférieur à 70 % lorsqu'il est exposé sous une lumière présentant une longueur d'onde de 240 nm ou plus, et contient des bulles d'air contenues substantiellement dans un matériau de poudres de quartz, dans une surface périphérique extérieure dudit creuset intérieur, présentant un diamètre moyen de bulles qui n'est pas supérieur à 40 µm, en une proportion ne dépassant pas 0,05 % du volume total dudit creuset intérieur.
